# EUROPEAN PATENT SPECIFICATION

(11) **EP 2 980 042 B1**
(45) Date of publication and mention of the grant of the patent: **09.10.2019**
(21) Application number: 14775875.9
(22) Date of filing: 18.03.2014
(51) Int. Cl.: C04B 35/111, H01L 33/48, C04B 35/119, H01L 33/60

(54) **SUBSTRATE FOR MOUNTING LIGHT-EMITTING ELEMENT, AND LIGHT-EMITTING ELEMENT MODULE**
TRÄGER ZUR MONTAGE EINES LICHTEMITTIERENDEN ELEMENTS UND MODUL MIT LICHTEMITTIERENDEN ELEMENTS
SUBSTRAT POUR LE MONTAGE D'UN ÉLÉMENT ÉLECTROLUMINESCENT ET MODULE D'ÉLÉMENTS ÉLECTROLUMINESCENTS

(30) Priority: 26.03.2013 JP 2013064297; 10.07.2013 JP 2013144705
(43) Date of publication of application: 03.02.2016
(73) Proprietor: Kyocera Corporation, Kyoto-shi, Kyoto 612-8501 (JP)
(72) Inventor: TOYODA,Satoshi, Kyoto-shi Kyoto 612-8501 (JP); TAKENOSHITA,Hidehiro, Kyoto-shi Kyoto 612-8501 (JP); FURUTACHI,Kenichi, Kyoto-shi Kyoto 612-8501 (JP)
(74) Representative: Viering, Jentschura & Partner mbB Patent- und Rechtsanwälte
(86) International application number: PCT/JP2014/057329
(87) International publication number: WO 2014/156831

(56) References cited:
- EP-A1- 2 415 728
- WO-A1-2012/015015
- WO-A1-2012/060341
- WO-A1-2012/060341
- DE-A1-102012 012 620
- JP-A- H06 116 017
- JP-A- 2009 046 326
- JP-A- 2011 222 674
- JP-A- 2011 241 131
- JP-A- 2011 241 131
- NILS CLAUSSEN: "Fracture Toughness of Al2O3 with an Unstabilized ZrO2 Dispersed Phase", JOURNAL OF THE AMERICAN CERAMIC SOCIETY,, vol. 59, no. 1-2, 1 January 1976 (1976-01-01), pages 49-51, XP001258341,

## Description

### Technical Field

The present invention relates to a light-emitting element mounting substrate and a light-emitting element module.

### Background Art

Light-emitting elements (LEDs) having the advantages of, for example, high luminance, long service life, and low electric power consumption are widely used as light sources of general lighting fixtures and sign boards with lamp, and also as backlights for liquid crystal displays of mobile phones, personal computers, television sets, and so forth.

A light-emitting element mounting substrate for the mounting of such a light-emitting element has electrodes formed on a surface thereof, and is thus made of a ceramic material which, while having insulation properties, excels in mechanical characteristics. As an example of such a light-emitting element mounting substrate made of a ceramic material, in Patent Literature 1, there is shown a proposal of a reflecting plate made of ceramics obtained by firing a mixture of alumina and zirconia.

### Citation List

### Patent Literature

Patent Literature 1: Japanese Unexamined Patent Publication JP-A 2011-222674.

Further relevant prior art is disclosed by WO 2012/060341 A1, EP 2 637 204 A1, JP 2011 241131 A and DE 10 2012 012620 A1.

### Summary of Invention

### Technical Problem

Although, in Patent Literature 1, it is described that Sample No. 5, which is a highest one in reflectivity as observed at 500 nm exhibits a reflectivity of 91.6%, higher and higher reflectivity is being sought now.

The invention has been devised to satisfy the requirement as mentioned supra, and accordingly an object of the invention is to provide a light-emitting element mounting substrate which exhibits high reflectivity in a visible-light range, and a light-emitting module having high reliability and high luminance.

### Solution to Problem

The invention provides a light-emitting element mounting substrate according to claim 1, including an alumina sintered body containing alumina crystal, zirconia crystal, and grain boundary phase, an intensity ratio Iₜ/Iₘ between a peak intensity Iₜ of tetragonal zirconia crystal at 2θ ranging from 30° to 30.5° and a peak intensity Iₘ of monoclinic zirconia crystal at 2θ ranging from 28° to 28.5° measured by an X-ray diffractometer using Cu-Kα radiation, being less than or equal to 35 excluding 0.

Moreover, the invention provides a light-emitting element module including the light-emitting element mounting substrate mentioned above; and a light-emitting element mounted thereon.

### Advantageous Effects of Invention

The light-emitting element mounting substrate pursuant to the invention has insulation properties, excels in mechanical characteristics, and exhibits high reflectivity in a visible-light range.

Moreover, the light-emitting element module pursuant to the invention is highly reliable, and also has high luminance.

### Brief Description of Drawings

FIG. 1 is a sectional view showing an example of a light-emitting element module obtained by mounting a light-emitting element on the light-emitting element mounting substrate of the present embodiment; and
FIG. 2 is a photomicrograph taken by a transmission electron microscope (TEM) showing lamellar-structured zirconia crystal contained in the light-emitting element mounting substrate of the present embodiment.

### Description of Embodiments

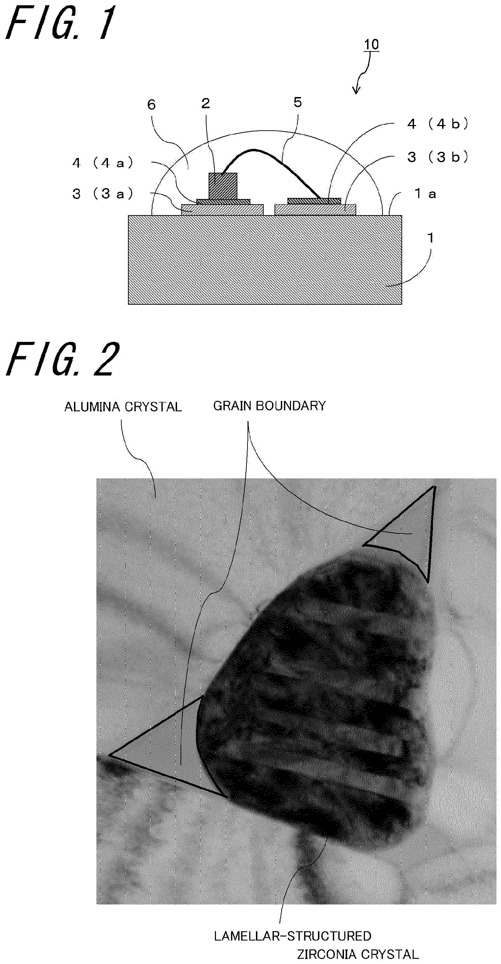

The following will describe an example of a light-emitting element mounting substrate in accordance with an embodiment of the invention and a light-emitting element module which is constructed by mounting a light-emitting element on the light-emitting element mounting substrate. FIG. 1 is a sectional view showing an example of a light-emitting element module obtained by mounting a light-emitting element on the light-emitting element mounting substrate of the present embodiment.

In the light-emitting element module 10 shown in FIG. 1, electrodes 3 (3a and 3b), and also electrode pads 4 (4a and 4b) are formed on a surface 1a of a light-emitting element mounting substrate 1 which is a base body. A light-emitting element 2 is mounted on the electrode pad 4a, and, the light-emitting element 2 and the electrode pad 4b are electrically connected to each other by a bonding wire 5. The light-emitting element 2, the electrodes 3, the electrode pads 4, and the bonding wire 5 are covered with a sealing member 6 made of resin or the like. The sealing member 6 not only provides protection for the light-emitting element 2 but also serves as a lens.

It is sufficient that the light-emitting element module 10 of the present embodiment be constructed by mounting the light-emitting element 2 on the light-emitting element mounting substrate 1 of the present embodiment. Thus, the light-emitting element module 10 is not limited to the construction as exemplified in FIG. 1. Moreover, in the present embodiment, the surface 1a of the light-emitting element mounting substrate 1 refers to a surface where the light-emitting element 2 is placed.

The light-emitting element mounting substrate 1 is formed of alumina sintered body containing alumina (Al₂O₃) crystal, zirconia (ZrO₂) crystal, and grain boundary phase. An intensity ratio Iₜ/Iₘ between a peak intensity Iₜ of tetragonal zirconia crystal (at 2θ = 30° to 30.5°) and a peak intensity Iₘ of monoclinic zirconia crystal (at 2θ = 28° to 28.5°) which peak intensities are measured by an X-ray diffractometer (XRD) using Cu-Kα radiation, is less than or equal to 35 excluding 0.

The light-emitting element mounting substrate 1 of the present embodiment fulfills the above structural requirements, and thus, while having insulation properties, excels in mechanical characteristics, and also exhibits high reflectivity in a visible-light range. Although the reason why improvement in reflectivity can be achieved is not fully clarified, presumably, the difference in intensity ratio, or equivalently abundance ratio, between tetragonal zirconia crystal and monoclinic zirconia crystal leads to a refractive index difference between tetragonal zirconia crystal and monoclinic zirconia crystal, as well as a refractive index difference between constituent zirconia crystal and alumina crystal, and these refractive index differences are conducive to an increase in the amount of regularly reflected light. The intensity ratio Iₜ/Iₘ should preferably be less than or equal to 15 excluding 0. In this case, even higher reflectivity can be imparted to the light-emitting element mounting substrate 1.

The alumina sintered body constituting the light-emitting element mounting substrate 1 of the present embodiment is characterized in that, according to a chart showing the result of measurement with the XRD using Cu-Kα radiation, alumina crystal exhibits a maximum peak. The maximum peak may be identified by verifying JCPDS card data. Moreover, the alumina sintered body is one in which, when viewed in section for observation of crystal portions constituting the light-emitting element mounting substrate 1, the area of alumina crystal measured by, for example, a scanning electron microscope (SEM) constitutes greater than 50% of the total area of the section, and also, the content of Al in terms of Al₂O₃ measured by an ICP (Inductively Coupled Plasma) emission spectrophotometer (ICP) and an X-ray fluorescence spectrometer (XRF) is greater than 50% by mass based on 100% by mass of all components constituting the sintered body.

A distinction between crystal and grain boundary phase can be made by examining, for example, the section for observation of crystal portions constituting the light-emitting element mounting substrate 1 with use of the SEM. Moreover, the use of an energy-dispersive X-ray spectroscope (EDS) attached to the SEM allows determination as to whether crystal under observation is alumina crystal or zirconia crystal. When Al and O are found, the crystal is determined to be alumina crystal, whereas, when Zr and O are found, the crystal is determined to be zirconia crystal.

Moreover, the intensity ratio Iₜ/Iₘ between tetragonal zirconia crystal and monoclinic zirconia crystal is derived on the basis of the value of the peak intensity Iₜ of tetragonal zirconia crystal at 2θ ranging from 30° to 30.5° and the value of the peak intensity Iₘ of monoclinic zirconia crystal at 2θ ranging from 28° to 28.5° obtained by measurement with the XRD using Cu-Kα radiation.

The light-emitting element mounting substrate 1 of the present embodiment exhibits high reflectivity in a visible-light range, and more specifically exhibits a reflectivity of higher than or equal to 93% at 500 nm when the intensity ratio Iₜ/Iₘ is less than or equal to 35 excluding 0. Reflectivity measurement may be conducted in conditions of a light source of D65 standard illuminant; a wavelength range of 360 to 740 nm, a field of view of 10 degrees; and illumination size of 3 × 5 mm with use of a spectrophotometric colorimeter (Model CM-3700A manufactured by Konica Minolta, Inc.).

Moreover, it is preferable that, in the light-emitting element mounting substrate 1 of the present embodiment, based on 100% by mass of all components constituting the alumina sintered body, the content of zirconia Zr in terms of ZrO₂ falls in the range of 5% by mass or above and 35% by mass or below. When the zirconia content falls in the range of 5% by mass or above and 35% by mass or below, the reflectivity can be further increased, and also improvement in mechanical characteristics can be achieved. More specifically, a reflectivity at 500 nm can be increased to 94% or above, and the three-point bending strength can be increased to 400 MPa or above.

The zirconia content can be determined by pulverizing part of the alumina sintered body constituting the light-emitting element mounting substrate 1, dissolving the resultant powder in a solution such as a hydrochloric acid solution for dilution, performing content measurement using the ICP, and converting the measured Zr content into ZrO₂ content. Moreover, the three-point bending strength is measured in conformity with JIS R 1601-2008 (ISO 17565: 2003 (MOD)).

Moreover, in the light-emitting element mounting substrate 1 of the present embodiment, at least part of zirconia crystal is lamellar-structured zirconia crystal. This lamellar-structured zirconia crystal will be described with reference to FIG. 2 showing a photomicrograph taken by a transmission electron microscope (TEM).

As shown in FIG. 2, the lamellar-structured zirconia crystal appears to have a multiple overlap of layers of different color tones. This is presumably because each layer has one of a cubic crystal structure, a tetragonal crystal structure, and a monoclinic crystal structure, and, adjacent layers have different crystal structures.

Although, in FIG. 2, the area of the lamellar-structured zirconia crystal forms a large proportion of the total area, in reality, the alumina crystal shown in FIG. 2 is only part thereof. It is thus needless to say that a scaled-down photomicrograph taken under a lower magnification will reveal that the area of alumina crystal constitutes greater than 50% of the total area. Moreover, as shown in FIG. 2, the light-emitting element mounting substrate 1 of the present embodiment comprises alumina crystal, zirconia crystal (lamellar-structured zirconia crystal as viewed in FIG. 2) and grain boundary phase.

In the case where at least part of zirconia crystal is lamellar-structured zirconia crystal, the light-emitting element mounting substrate 1 is capable of exhibiting even higher reflectivity in a visible-light range. This is presumably because, since the lamellar-structured zirconia crystal has a multiple overlap of layers of different crystal structures, it follows that refractive index differences are also caused within the lamellar-structured zirconia crystal.

The lamellar-structured zirconia crystal is presumably developed when a stress resulting from the difference in thermal expansion between alumina crystal and zirconia crystal acts, as a tensile stress or compressive stress, on zirconia crystal existing between alumina crystal portions during firing process.

It is preferable that the ratio of the number of lamellar-structured zirconia crystal portions to the number of zirconia crystal portions is greater than or equal to 50%. In the case where the ratio of the number of lamellar-structured zirconia crystal portions to the number of zirconia crystal portions is greater than or equal to 50%, the reflectivity can be further increased.

The following will describe a way to recognize lamellar-structured zirconia crystal. The first step is to etch part of the light-emitting element mounting substrate 1 with a working machine such as an ion-beam thinning apparatus to obtain a surface of measurement. Next, the measurement surface is examined at a specific field of view by observation under a TEM of magnifications ranging from 10000 times to 100000 times in a condition of an accelerating voltage of 200 kV. Under observation, alumina crystal looks white, whereas zirconia crystal looks black, wherefore the presence of lamellar-structured zirconia crystal can be determined by checking whether the black-looking crystal has a multiple overlap of layers of different color tones. When an identification of zirconia crystal is difficult, it is advisable to check the presence or absence of Zr and O with the attached EDS.

Next, in determining the ratio of the number of lamellar-structured zirconia crystal portions to the number of zirconia crystal portions by calculation, the following steps are performed: the number of zirconia crystal portions at the aforementioned specific field of view is defined as X; the number of zirconia crystal portions that appear to have a multiple overlap of layers of different color tones (lamellar-structured zirconia crystal portions) is defined as Y; a ratio between them at a single specific field of view is derived in accordance with a mathematical expression given by: Y/X × 100; a ratio between them at each of the other four specific fields of view (a total of five measurement points) is derived; and all the ratio values are averaged, and an average value is defined as the ratio of the number of lamellar-structured zirconia crystal portions to the number of zirconia crystal portions in the present embodiment.

Moreover, it is preferable that, in the light-emitting element mounting substrate 1 of the present embodiment, glass containing at least silicon oxide and magnesium oxide is present in the grain boundary phase, and the content of the glass falls in the range of 1% by mass or above and 6% by mass or below. The fulfillment of this structural requirement makes it possible to achieve further improvement in reflectivity while suppressing a decrease in thermal conductivity. The presence of glass which differs in refractive index from both of alumina crystal and zirconia crystal in the grain boundary phase is conducive to improvement in reflectivity. In the present embodiment, the grain boundary phase refers to a region other than alumina crystal and zirconia crystal, and, glass may contain, in addition to silicon oxide and magnesium oxide, for example, calcium oxide, boron oxide, zinc oxide, and bismuth oxide. The glass content as described herein is represented by the percentage of glass based on 100% by mass of all components constituting the alumina sintered body constituting the light-emitting element mounting substrate 1.

The presence of glass may be checked by, after cutting the light-emitting element mounting substrate 1 and polishing the section of the cut to a mirror-smooth state, examining a plurality of grain boundary phases by observation under a TEM (Transmission Electron Microscope) of magnifications ranging from 10000 times to 150000 times. The check may alternatively be made by examining the presence or absence of a so-called broad halo pattern by measurement with the XRF. Note that glass can be judged as being present also when no crystal other than alumina crystal and zirconia crystal was found under measurement with the XRD in spite of the fact that an element other than Al and Zr was detected by qualitative analysis using the EDS, XRF, or ICP attached to the SEM.

Under measurement with the XRD, when no crystal other than alumina crystal and zirconia crystal is found, or when a detected peak intensity is less than or equal to only one-twentieth part of the peak intensity of alumina as observed when 2θ ranges from 34° to 36°, then, in the present embodiment, the content of glass is defined by the sum of values obtained by converting quantitative values of elements detected by qualitative analysis, such for example as Si, Mg, Ca, B, Zn, and Bi, into SiO₂, MgO, CaO, B₂O₃, ZnO, and Bi₂O₃, respectively.

It is preferable that, in the glass, based on 100% by mass of components constituting the glass, the content of silicon oxide falls in the range of 50% by mass or above and 70% by mass or below, the content of magnesium oxide is greater than or equal to 30% by mass and less than 50% by mass, and the content of the sum of the aforementioned other oxides is less than 10% by mass.

Moreover, it is preferable that the relative density of the alumina sintered body constituting the light-emitting element mounting substrate 1 of the present embodiment falls in the range of 86% or above and 92% or below. In the case where the relative density falls in the range of 86% or above and 92% or below, it is possible to attain higher reflectivity by virtue of the presence of pores at the surface of the light-emitting element mounting substrate 1 while suppressing a deterioration in mechanical characteristics.

The relative density can be determined by, in conformity with JIS R 1634-1998, obtaining the apparent density of the light-emitting element mounting substrate made of alumina sintered body, and whereafter dividing the apparent density by the theoretical density of the alumina sintered body constituting the light-emitting element mounting substrate 1.

Moreover, it is preferable that MgAl₂O₄ crystal is present in the grain boundary phase of the light-emitting element mounting substrate 1 of the present embodiment. In the presence of MgAl₂O₄ crystal in the grain boundary phase, grain growth of alumina crystal, the area of which occupies greater than 50% of the total area, can be suppressed, thus enabling formation of finer and more homogeneous crystal structure with consequent improvement in mechanical characteristics.

Moreover, it is preferable that Al_{0.52}Zr_{0.48}O_{1.74} is present in the grain boundary phase of the light-emitting element mounting substrate 1 of the present embodiment. In the presence of Al_{0.52}Zr_{0.48}O_{1.74} in the grain boundary phase, grain growth of alumina crystal, the area of which occupies greater than 50% of the total area, can be suppressed, thus enabling formation of finer and more homogeneous crystal structure with consequent improvement in mechanical characteristics. Since Al_{0.52}Zr_{0.48}O_{1.74} exhibits a main peak at 2θ ranging from 35.1° to 35.2° according to the result of measurement with the XRD using Cu-Kα radiation, it is possible to verify the presence of Al_{0.52}Zr_{0.48}O_{1.74} by checking whether the peak is found within the above specified range.

The light-emitting element module 10 of the present embodiment, being equipped with the light-emitting element mounting substrate 1 of the present embodiment made of alumina sintered body containing alumina as main crystal, and in addition zirconia, is excellent in insulation proparties and in mechanical characteristics, and thus affords high reliability. Moreover, in the light-emitting element module 10, by virtue of its high reflectivity, light emitted from a light-emitting element can be reflected with high reflectivity, thus affording high luminance in addition to high reliability.

The following will describe an example of a method for manufacturing the light-emitting element mounting substrate 1 of the present embodiment.

The first step is to prepare alumina (Al₂O₃) powder, and magnesium hydroxide (Mg(OH)₂) powder, silicon oxide (SiO₂) powder, and calcium carbonate (CaCO₃) powder used as sintering aids, and powder of zirconia (ZrO₂) which has not been stabilized. The unstabilized zirconia powder refers to powder of zirconia which has not been stabilized by a stabilizer such as yttrium oxide (Y₂O₃), dysprosium oxide (Dy₂O₃), cerium oxide (CeO₂), calcium oxide (CaO), or magnesium oxide (MgO).

Although some substances play overlapping roles both as a sintering aid and a stabilizer, what matters is the use of unstabilized zirconia powder as a starting material. Therefore, there is no problem even if zirconia is partly stabilized by a sintering aid during sintering process. Moreover, MgAl₂O₄ can be developed in the grain boundary phase when an average particle size of alumina powder is less than 1 µm, and also the average particle size of magnesium hydroxide is less than 1.5 µm. Furthermore, Al_{0.52}Zr_{0.48}O_{1.74} can be developed in the grain boundary phase when both of alumina powder and zirconia powder in use have a particle size of less than 1 µm.

There may be a case where, in the light-emitting element mounting substrate 1 of the present embodiment, tetragonal zirconia exists in spite of the use of unstabilized zirconia powder. This is presumably ascribable to occurrence of transformation, or formation of a solid solution of Ca of calcium carbonate powder and Mg of magnesium hydroxide powder used as sintering aids. Next, predetermined amounts of these powdery materials are weighed out to prepare primary raw material powder. More specifically, it is desirable to conduct the weighing in a manner such that, based on 100% by mass of a total of sintering aids, alumina powder, and zirconia powder, the content of sintering aids is 1 to 6% by mass, the content of zirconia powder is 5 to 35% by mass, and the remainder is alumina powder.

Next, based on 100% by mass of the thereby weighed primary raw material powder, a binder such as PVA (polyvinyl alcohol) in an amount of 1 to 1.5% by mass, a solvent in an amount of 100% by mass, and a dispersant in an amount of 0.1 to 0.5% by mass are put in an agitator, and these materials are mixed and stirred to prepare a slurry.

After that, a sheet is formed using the slurry by the doctor blade method, or, after the slurry is granulated in spray granulation process using a spray-granulating machine (spray dryer), a sheet is formed using the resultant granules by the roller compaction method. Then, the sheet is subjected to die press working or lasering to obtain a molded body having the shape of a predetermined product or a shape analogous to the product. At this time, in the interest of mass production of the light-emitting element mounting substrate 1, the molded body should preferably be formed with slits so as to be dividable into multiple pieces.

The thereby obtained molded body is retained, while being fired, for a predetermined period of time at a maximum temperature in the range of 1400°C or above and 1600°C or below in a firing furnace under air (oxidative) atmosphere (for example, a roller type tunnel furnace, a batch atmosphere furnace, or a pusher type tunnel furnace), whereby the light-emitting element mounting substrate 1 of the present embodiment is produced. Note that, needless to say, as a way to obtain multiple light-emitting element mounting substrates 1, the slits may be formed after firing process.

Moreover, to cause lamellar-structured zirconia crystal to be developed as at least part of zirconia crystal, firing is effected in a condition where the rate of a temperature rise up to the maximum temperature is 400°C/h or above. Furthermore, to adjust the ratio of the number of lamellar-structured zirconia crystal portions to the number of zirconia crystal portions to be greater than or equal to 50%, firing is effected in a condition where the rate of a temperature rise up to the maximum temperature is 500°C/h or above. In addition, to adjust the relative density to fall in the range of 86% or above and 92% or below, the maximum temperature for firing process is set in the range of 1400°C or above and 1500°C or below.

Moreover, the reflectivity of the light-emitting element mounting substrate 1 can be increased by performing heat treatment at a temperature of higher than or equal to 500°C following the completion of firing. The reason why improvement in reflectivity can be achieved is presumably because the intensity ratio Iₜ/Iₘ between the peak intensity Iₜ of tetragonal zirconia and the peak intensity Iₘ of monoclinic zirconia in the light-emitting element mounting substrate is reduced around the time of heat treatment, that is; monoclinic zirconia is increased by the heat treatment. Note that, when the heat treatment temperature exceeds 1100°C, transformation from monoclinic crystal to tetragonal crystal will occur, and also the heat treatment may cause not some little deterioration of mechanical characteristics, wherefore it is advisable that the upper limit of the temperature for the heat treatment is lower than 1100°C.

Since improvement in reflectivity can be achieved by the aforestated heat treatment, even if the content of zirconia is low, for example, as low as 5 to 10% by mass, it is possible to attain substantially the same reflectivity as obtained in a case where zirconia is contained in an amount of about 30% by mass. Thus, from the standpoint of reducing material costs while making the most of the advantageous effect specific to the present application, it is advisable to adjust the content of zirconia in the range of 5 to 10% by mass, as well as to perform heat treatment.

Moreover, to cause glass to exist in the grain boundary phase, firing is effected in a condition where the rate of a temperature decrease from the maximum temperature to room temperature falls in the range of 250°C/h or higher and 400°C/h or lower.

Next, an example of a method for manufacturing the light-emitting element module 10 of the present embodiment will be described with reference to FIG. 1. With the light-emitting element mounting substrate 1 of the present embodiment set in place as a base body, the electrodes 3 (3a and 3b) are formed on the surface 1a of the light-emitting element mounting substrate 1 by a thick-film printing method. Then, the electrode pads 4 (4a and 4b) are formed on the electrodes 3, respectively, by means of plating or otherwise. Next, the semiconductor-made light-emitting element 2 is mounted on the electrode pad 4a. Then, the light-emitting element 2 and the electrode pad 4b are electrically connected to each other via the bonding wire 5 by means of conductive-adhesive bonding or solder-bump bonding. Next, the electrodes 3 and the electrode pads 4 are coated with a glass overcoat for protection. Lastly, the sealing member 6 made of resin or the like is applied to cover the components, whereby the light-emitting element module 10 of the present embodiment is produced.

Now, examples of the invention will be specifically described, but it is noted that the invention is not limited to these examples. Some of the following samples do not form part of the invention, which is defined by the appended claims.

### Example 1

There were produced light-emitting element mounting substrates with varying peak intensity ratio Iₜ/Iₘ between tetragonal zirconia crystal and monoclinic zirconia crystal, and each substrate was subjected to reflectivity measurement and three-point bending strength measurement.

### (1) Preparation of granules used for samples Nos. 1 to 12

To begin with, there were prepared: alumina powder having an average particle size of 1.0 µm; sintering aids including magnesium hydroxide powder having an average particle size of 1.0 µm, silicon oxide powder having an average particle size of 1.0 µm, and calcium carbonate powder having an average particle size of 1.0 µm; and unstabilized zirconia powder having an average particle size of 2.0 µm.

Then, a primary raw material was prepared by performing weighing in a manner such that, based on 100% by mass of all components constituting each sample, the content of unstabilized zirconia powder is as listed in Table 1; the content of magnesium hydroxide powder in terms of MgO is 1.3% by mass; the content of silicon oxide powder in terms of SiO₂ is 1.9% by mass; the content of calcium carbonate powder in terms of CaO is 0.3% by mass; and the remainder is alumina powder.

Next, with 100% by mass of the thereby weighed primary raw material powder, 1.0% by mass of PVA, 100% by mass of a solvent, and 0.2% by mass of a dispersant were put in an agitator, and these materials were mixed and stirred to prepare a slurry. After that, granules were obtained by subjecting the slurry to spray granulation process using a slurry-granulating machine (spray dryer).

### (2) Preparation of granules used for sample No. 13

Granules were obtained by following the procedure adopted in the preparation (1), except that zirconia powder was not added.

### (3) Preparation of granules used for sample No. 14

Granules were obtained by following the procedure adopted in the preparation(1), except that, as the zirconia powder, one which was stabilized in advance by 3% by mole of Y₂O₃ was used. In the preparation (3), the weighing of zirconia powder was conducted in a manner such that, based on 100% by mass of all components constituting the sample No. 14, the content of zirconia is 20% by mass.

Next, the granules obtained in each preparation process were press-worked into a molded body in plate form and a molded body in rod form with molds adapted for the formation of the plate and rod forms. The plate-like molded body is used for peak intensity measurement and reflectivity measurement, whereas the rod-like molded body is used for three-point bending strength measurement. Then, the thereby obtained molded bodies were put in a firing furnace under air (oxidative) atmosphere, and fired at a maximum temperature of 1500°C. After the firing process, the molded bodies were ground into a square plate-like body which is 10 mm on a side and 1.0 mm in thickness and a rod-like body having dimensions conforming to JIS R 1601-2008 (ISO 17565: 2003 (MOD)), respectively.

Then, in each sample, an intensity ratio Iₜ/Iₘ was determined by calculation on the basis of the value of the peak intensity Iₜ of tetragonal zirconia crystal at 2θ ranging from 30° to 30.5° and the value of the peak intensity Iₘ of monoclinic zirconia crystal at 2θ ranging from 28° to 28.5° obtained by measurement with the XRD (X'PertPRO manufactured by PANAlytical) using Cu-Kα radiation.

Moreover, in each sample, reflectivity measurement was conducted in conditions of a light source of D65 standard illuminant; a wavelength range of 360 to 740 nm, a field of view of 10°; and illumination size of 3 × 5 mm with use of spectrophotometric colorimeter (Model CM-3700A manufactured by Minolta), and subsequently three-point bending strength measurement was conducted in conformity with JIS R 1601-2008 (ISO 17565: 2003 (MOD)). The values of intensity ratio I_{t/}Iₘ, reflectivity at a visible light wavelength of 500 nm, and three-point bending strength are shown in Table 1.

Then, the content of zirconia was determined by pulverizing part of each sample, dissolving the resultant powder in a solution such as a hydrochloric acid solution for dilution, performing measurement using an ICP emission spectrophotometer (ICPS-8100 manufactured by Shimadzu Corporation), and converting the measured Zr content into ZrO₂ content. Moreover, the content of sintering aids and the content of alumina were found to conform to their corresponding addition amounts. Furthermore, each sample was found to have a relative density of 90%.

**[Table 1]**

| Sample No. | Zirconia content (mass%) | Iₜ/Iₘ | Reflectivity (%) | Three-point bending strength (MPa) |
|---|---|---|---|---|
| 1 | 0.5 | 36.0 | 92,5 | 330 |
| 2 | 1 | 35.0 | 93.0 | 350 |
| 3 | 3 | 33.3 | 93.6 | 380 |
| 4 | 5 | 32.0 | 94.0 | 400 |
| 5 | 7 | 28.0 | 94.5 | 420 |
| 6 | 10 | 15.0 | 94.8 | 450 |
| 7 | 15 | 6.0 | 95.2 | 550 |
| 8 | 20 | 2.0 | 95.2 | 520 |
| 9 | 30 | 0.3 | 95.5 | 500 |
| 10 | 35 | 0.2 | 95.8 | 440 |
| 11 | 40 | 0.1 | 96.0 | 390 |
| 12 | 45 | 0.05 | 96.0 | 300 |
| 13 | 0 | - | 89.5 | 340 |
| 14 | 20 | 40.0 | 92.0 | 520 |

It will be noted from Table 1 that the sample No. 13 in which zirconia powder is not added has a reflectivity of as low as 89.5% at 500 nm. Moreover, in the sample No. 14 in which stabilized zirconia powder is added, the proportion of tetragonal zirconia is high and the value of intensity ratio Iₜ/Iₘ is 40.0, and thus the reflectivity, while being higher than that of the sample No. 13, stands at 92.0%. Furthermore, in the sample No. 1, the value of intensity ratio Iₜ/Iₘ is 36.0, and the reflectivity is 92.5% at 500 nm. Said samples No. 1, 13 and 14 do not form part of the invention.

On the other hand, the samples Nos. 2 to 12 in which the intensity ratio Iₜ/Iₘ is less than or equal to 35 excluding 0 has a reflectivity of 93.0% or above at 500 nm, that is; the samples Nos. 2 to 12 was found to have a high reflectivity.

Moreover, in the samples Nos. 4 to 10 in which the content of zirconia falls in the range of 5% by mass or above and 35% by mass or below, the reflectivity is 94.0% or above at 500 nm, and the three-point bending strength is 400 MPa or above, that is; the samples numbered 4 to 10 were found to serve the purpose of producing a light-emitting element mounting substrate of high reflectivity and high strength.

### Example 2

Next, plate-like bodies and rod-like bodies were obtained by the same procedure as adopted in the production of the sample No. 5 of Example 1. The bodies were heat-treated at temperatures as shown in Table 2, and then, as is the case with Example 1, subjected to intensity ratio Iₜ/Iₘ measurement with the XRD, reflectivity measurement, and three-point bending strength measurement. The measurement results are shown in Table 2.

**[Table 2]**

| Sample No. | Heat -treatment temperature (°C) | Iₜ/Iₘ | Reflectivity (%) | Three-point bending strength (MPa) |
|---|---|---|---|---|
| 15 | 400 | 28.0 | 94.5 | 420 |
| 16 | 500 | 21.0 | 94.7 | 415 |
| 17 | 600 | 15.0 | 94.9 | 410 |
| 18 | 700 | 8.0 | 95.2 | 405 |
| 19 | 800 | 4.0 | 95.4 | 400 |
| 20 | 900 | 2.0 | 95.5 | 390 |
| 21 | 1000 | 1.5 | 95.6 | 380 |
| 22 | 1100 | 2.0 | 95.4 | 360 |

It will be noted from Table 2 that improvement in reflectivity can be achieved by effecting heat treatment at a temperature of 500°C or above. However, the numerical value of intensity ratio Iₜ/Iₘ corresponding to the case of effecting heat treatment at a temperature of 1100°C is greater than that corresponding to the case of effecting heat treatment at a temperature of 1000°C. Although it is not clear whether this phenomenon is caused by transformation from monoclinic crystal to tetragonal crystal, for some reason, when heat treatment is effected at 1100°C, the reflectivity is no longer increased, and the rate of a decline in three-point bending strength is increased. It has thus been understood that heat treatment should preferably be conducted at temperatures ranging from 500°C or above to 1000°C or below.

### Example 3

Next, there were produced samples with varying rates of a firing temperature rise up to the maximum temperature, and, on these samples, the presence or absence of lamellar-structured zirconia crystal was measured, the ratio of the number of lamellar-structured zirconia crystal portions to the number of zirconia crystal portions was calculated, and reflectivity was measured. The samples in plate-like form were produced by the same procedure as adopted in the production of the sample No. 2 of Example 1, except that the rate of a firing temperature rise up to the maximum temperature was varied. Moreover, reflectivity measurement was conducted by the same method as adopted in Example 1.

The presence or absence of lamellar-structured zirconia crystal was checked by, after etching each sample by an ion-beam thinning apparatus to obtain a surface of measurement, examining the measurement surface by observation under a TEM (JEM-2010F manufactured by JEOL Ltd.) of a magnification of 50000 times in a condition of an accelerating voltage of 200 kV. Moreover, in determining the ratio of the number of lamellar-structured zirconia crystal portions to the number of zirconia crystal portions by calculation, the following steps were performed: the number of zirconia crystal portions at a specific field of view (14 µm × 12 µm) observed under the TEM was defined as X; the number of zirconia crystal portions that appeared to have a multiple overlap of layers of different color tones (lamellar-structured zirconia crystal portions) was defined as Y; a ratio between X and Y at a single specific field of view was derived in accordance with a mathematical expression given by: Y/X × 100; a ratio between X and Y at each of the other four specific fields of view (a total of five measurement points) was derived; and, after all the ratio values were averaged, the average value was defined as the ratio of the number of lamellar-structured zirconia crystal portions to the number of zirconia crystal portions. The calculation results are shown in Table 3.

**[Table 3]**

| Sample No. | Rate of temperature rise (°C/h) | Presence or absence of lamellar-structured zirconia crystal | Ratio (%) | Reflectivity (%) |
|---|---|---|---|---|
| 23 | 350 | Not found | 0 | 93.0 |
| 24 | 400 | Found | 30 | 93.5 |
| 25 | 500 | Found | 50 | 94.0 |
| 26 | 650 | Found | 70 | 94.3 |
| 27 | 800 | Found | 90 | 94.6 |
| 28 | 1000 | Found | 95 | 95.0 |
| 29 | 1200 | Found | 95 | 95.0 |

It will be noted from Table 3 that, by effecting firing in a condition where the rate of a temperature rise up to the maximum temperature is 400°C/h or above, it is possible to develop lamellar-structured zirconia crystal, and thereby achieve improvement in reflectivity, and that, by adjusting the ratio of the number of lamellar-structured zirconia crystal portions to the number of zirconia crystal portions to be greater than or equal to 50%, it is possible to achieve further improvement in reflectivity. Sample No.23 does not form part of the invention.

### Example 4

Next, there were produced samples with varying sintering aid amounts, and, reflectivity measurement and thermal conductivity measurement were conducted on each sample. The samples were produced by the same procedure as adopted in the production of the sample No. 19 of Example 2, except that the contents of sintering aids are as listed in Table 4. Reflectivity measurement was conducted by the same method as adopted in Example 1. Moreover, thermal conductivity measurement was conducted in conformity with JIS R 1611-1997.

Moreover, under measurement with the XRD, except for alumina and zirconia, there was detected only a peak intensity of less than or equal to one-twentieth part of the peak intensity of alumina as observed when 2θ ranges from 34° to 36°. Therefore, Si, Mg, and Ca that were identified by qualitative analysis using the XRF were subjected to quantitative analysis using the ICP, and their values were converted into SiO₂, MgO, and CaO, respectively. The samples No. 33 and No. 19 are identical.

**[Table 4]**

| Sample No. | SiO₂ (mass%) | MgO (mass%) | CaO (mass%) | Total (mass%) | Reflectivity (%) | Thermal conductivity (W/(m·K)) |
|---|---|---|---|---|---|---|
| 30 | 0.5 | 0.25 | 0.1 | 0.85 | 95.0 | 22 |
| 31 | 0.6 | 0.4 | 0 | 1.0 | 95.2 | 22 |
| 32 | 1.2 | 0.7 | 0.1 | 2.0 | 95.3 | 20 |
| 33 | 1.9 | 1.3 | 0.3 | 3.5 | 95.4 | 19 |
| 34 | 3.6 | 1.8 | 0.6 | 6.0 | 95.6 | 17 |
| 35 | 3.8 | 2.0 | 0.7 | 6.5 | 95.6 | 15 |

It will be noted from Table 4 that, when glass containing at least magnesium oxide and silicon oxide is present in the grain boundary phase, and the content of the glass falls in the range of 1% by mass or above and 6% by mass or below, it is possible to achieve improvement in reflectivity while suppressing a decrease in thermal conductivity.

### Example 5

Next, there were produced samples with varying time periods for retention at the maximum temperature in firing process, and, reflectivity measurement and three-point bending strength measurement were conducted on each sample. The sample No. 39 was identical with the sample No. 19, and, the samples were produced while making numbering so that a retention period at the maximum temperature is decreased as the sample No. becomes increasingly large. Reflectivity measurement and three-point bending strength measurement were conducted by the same method as adopted in Example 1. Moreover, the relative density of each sample was determined by calculation. The measurement results are shown in Table 5.

**[Table 5]**

| Sample No. | Relative density (%) | Reflectivity (%) | Three-point bending strength (MPa) |
|---|---|---|---|
| 36 | 93 | 94.9 | 420 |
| 37 | 92 | 95.2 | 414 |
| 38 | 91 | 95.3 | 407 |
| 39 | 90 | 95.4 | 400 |
| 40 | 88 | 95.8 | 390 |
| 41 | 86 | 96.0 | 385 |
| 42 | 85 | 96.0 | 380 |

It will be noted from Table 5 that the relative density should preferably fall in the range of 86% or above and 92% or below to attain higher reflectivity by virtue of the presence of pores at the surface of the light-emitting element mounting substrate while suppressing a deterioration in mechanical characteristics.

### Example 6

Next, plate-like bodies and rod-like bodies were obtained by the same procedure as adopted in the production of the sample No. 6 of Example 1, except that alumina powder having an average particle size of 0.8 µm and magnesium hydroxide powder having an average particle size of 1 µm were used for the primary raw material. Then, as is the case with Example 1, the bodies were subjected to measurement with the XRD, reflectivity measurement, and three-point bending strength measurement.

As a result, the sample according to this example was found to contain MgAl₂O₄, and, a comparison of this sample with the sample No. 6 indicated that, although these samples were equal in intensity ratio Iₜ/Iₘ and reflectivity to each other, in contrast to the sample No. 6, the sample of Example 6 achieved a 5% increase in three-point bending strength. It has thus been understood that the presence of MgAl₂O₄ allows improvement in mechanical characteristics.

### Example 7

Next, plate-like bodies and rod-like bodies were obtained by the same procedure as adopted in the production of the sample No. 6 of Example 1, except that alumina powder having an average particle size of 0.8 µm and unstabilized zirconia powder having an average particle size of 0.8 µm were used for the primary raw material. Then, as is the case with Example 1, the bodies were subjected to measurement with the XRD, reflectivity measurement, and three-point bending strength measurement.

As a result, the sample according to this example was found to contain Al_{0.52}Zr_{0.48}O_{1.74}, and, a comparison of this sample with the sample No. 6 indicated that, although these samples were equal in intensity ratio Iₜ/Iₘ and reflectivity to each other, in contrast to the sample No. 6, the sample of Example 7 achieved a 5% increase in three-point bending strength. It has thus been understood that the presence of Al_{0.52}Zr_{0.48}O_{1.74} allows improvement in mechanical characteristics.

The results of measurements performed on the examples thus far described prove that the light-emitting element mounting substrate of the invention is excellent in insulation proparties and in mechanical characteristics, and the light-emitting element module constructed by mounting a light-emitting element on the light-emitting element mounting substrate of the invention affords high luminance in addition to high reliability.

### Reference Signs List

- 1:: Light-emitting element mounting substrate
- 1a:: Surface
- 2:: Light-emitting element
- 3:: Electrode
- 4:: Electrode pad
- 5:: Bonding wire
- 6:: Sealing member
- 10:: Light-emitting element module

## Claims

1. A light-emitting element mounting substrate, comprising:
an alumina sintered body containing alumina crystal, zirconia crystal, and grain boundary phase,
an intensity ratio Iₜ/Iₘ between a peak intensity Iₜ of tetragonal zirconia crystal at 2θ ranging from 30° to 30.5° and a peak intensity Iₘ of monoclinic zirconia crystal at 2θ ranging from 28° to 28.5° measured by an X-ray diffractometer using Cu-Kα radiation, being less than or equal to 35 excluding 0,
**characterized in that** at least part of the zirconia crystal is lamellar-structured zirconia crystal.

2. The light-emitting element mounting substrate according to claim 1,
wherein, based on 100% by mass of all components constituting the alumina sintered body, a content of Zr in terms of ZrO₂ falls in a range of 5% by mass or above and 35% by mass or below.

3. The light-emitting element mounting substrate according to claim 1 or 2,
wherein glass containing at least magnesium oxide and silicon oxide is present in the grain boundary phase, and
a content of the glass falls in a range of 1% by mass or above and 6% by mass or below.

4. The light-emitting element mounting substrate according to any one of claims 1 to 3,
wherein a relative density of the alumina sintered body falls in a range of 86% or above and 92% or below.

5. The light-emitting element mounting substrate according to any one of claims 1 to 4,
wherein crystal which is expressed by MgAl₂O₄ is present in the grain boundary phase.

6. The light-emitting element mounting substrate according to any one of claims 1 to 5,
wherein crystal which is expressed by Al_{0.52}Zr_{0.48}O_{1.74} is present in the grain boundary phase.

7. A light-emitting element module, comprising:
the light-emitting element mounting substrate according to any one of claims 1 to 6; and
a light-emitting element mounted thereon.

## Patentansprüche

1. Ein lichtemittierendes-Element-Montagesubstrat, aufweisend:
einen Aluminiumoxid-Sinterkörper, der Aluminiumoxidkristall, Zirkonoxidkristall und Korngrenzenphase enthält,
wobei ein Intensitätsverhältnis Iₜ/Iₘ zwischen einer Peakintensität Iₜ von tetragonalem Zirkonoxidkristall bei 2θ im Bereich von 30° bis 30,5° und einer Peakintensität Iₘ von monoklinem Zirkonoxidkristall bei 2θ im Bereich von 28° bis 28,5°, gemessen mit einem Röntgenbeugungsmesser unter Verwendung von Cu-Ka-Strahlung, kleiner oder gleich 35 ausgenommen 0 ist,
**dadurch gekennzeichnet, dass**
zumindest ein Teil des Zirkonoxidkristalls lamellar strukturierter Zirkonoxidkristall ist.

2. Das lichtemittierendes-Element-Montagesubstrat gemäß Anspruch 1,
wobei, basierend auf 100 Masse-% aller Komponenten, die den Aluminiumoxid-Sinterkörper bilden, ein Gehalt an Zr in Form von Zr0₂ in einem Bereich von 5 Masse-% oder mehr und 35 Masse-% oder weniger liegt.

3. Das lichtemittierendes-Element-Montagesubstrat gemäß Anspruch 1 oder 2,
wobei Glas, das mindestens Magnesiumoxid und Siliciumoxid enthält, in der Korngrenzenphase vorhanden ist, und
ein Gehalt des Glases in einem Bereich von 1 Masse-% oder mehr und 6 Masse-% oder weniger liegt.

4. Das lichtemittierendes-Element-Montagesubstrat gemäß irgendeinem der Ansprüche 1 bis 3,
wobei eine relative Dichte des Aluminiumoxid-Sinterkörpers in einem Bereich von 86% oder mehr und 92% oder weniger liegt.

5. Das lichtemittierendes-Element-Montagesubstrat gemäß irgendeinem der Ansprüche 1 bis 4,
wobei ein Kristall, der durch MgAl₂O₄ ausgedrückt ist, in der Korngrenzenphase vorhanden ist.

6. Das lichtemittierendes-Element-Montagesubstrat gemäß irgendeinem der Ansprüche 1 bis 5,
wobei ein Kristall, der durch Al_{0,52}Zr_{0,48}O_{1,74} ausgedrückt ist, in der Korngrenzenphase vorhanden ist.

7. Ein lichtemittierendes-Element-Modul, aufweisend:
das lichtemittierendes-Element-Montagesubstrat gemäß irgendeinem der Ansprüche 1 bis 6 und
ein darauf montiertes lichtemittierendes Element.

## Revendications

1. Un substrat de montage d'élément électroluminescent, comprenant :
un corps fritté en alumine contenant du cristal d'alumine, du cristal de zircone et une phase de limite de grains,
dans lequel un rapport d'intensité Iₜ/Iₘ entre une intensité de pic Iₜ de cristal de zircone tétragonal à 2θ allant de 30° à 30,5° et une intensité de pic Iₘ de cristal de zircone monoclinique à 2θ allant de 28° à 28,5°, mesuré par diffractomètre à rayons X à rayonnement Cu-Ka, est inférieur ou égal à 35 hors 0,
**caractérisé en ce que**
au moins une partie du cristal de zircone est un cristal de zircone à structure lamellaire.

2. Le substrat de montage d'élément électroluminescent selon la revendication 1,
dans lequel, sur la base de 100 % en masse de tous les composants constituant le corps fritté en alumine, une teneur en Zr en termes de ZrO₂ se situe dans une plage de 5 % en masse ou plus et 35 % en masse ou moins.

3. Le substrat de montage d'élément électroluminescent selon la revendication 1 ou 2,
dans lequel du verre contenant au moins de l'oxyde de magnésium et de l'oxyde de silicium est présent dans la phase de limite de grains, et
une teneur en ledit verre se situe dans une plage de 1 % en masse ou plus et 6 % en masse ou moins.

4. Le substrat de montage d'élément électroluminescent selon l'une quelconque des revendications 1 à 3,
dans lequel une densité relative du corps fritté en alumine se situe dans une plage de 86 % ou plus et 92 % ou moins.

5. Le substrat de montage d'élément électroluminescent selon l'une quelconque des revendications 1 à 4,
dans lequel le cristal qui est exprimé par MgAl₂O₄ est présent dans la phase de limite de grains.

6. Le substrat de montage d'élément électroluminescent selon l'une quelconque des revendications 1 à 5,
dans lequel le cristal qui est exprimé par Al_{0,52}Zr_{0,48}O_{1,74} est présent dans la phase de limite de grains.

7. Un module d'élément électroluminescent, comprenant :
le substrat de montage d'élément électroluminescent selon l'une quelconque des revendications 1 à 6, et
un élément électroluminescent monté sur celui-ci.
